# EUROPEAN PATENT APPLICATION

(11) **EP 3 483 614 A1**
(43) Date of publication of application: **15.05.2019**
(21) Application number: 16907690.8
(22) Date of filing: 07.07.2016
(51) Int. Cl.: G01R 22/10

(54) **DIGITAL ELECTRONIC METER FOR ELECTRICAL MAGNITUDES WITH SIX OR MORE MEASUREMENT ELEMENTS**

(71) Applicant: Saletti, Luiz Paulo, Porto Alegre (BR)
(72) Inventor: Saletti, Luiz Paulo, Porto Alegre (BR)
(74) Representative: Pereira Garcia, João Luís
(86) International application number: PCT/BR2016/050157
(87) International publication number: WO 2018/006144

(57) **Abstract**

A digital electronic meter of electrical quantities with six or more measuring elements is described which comprises a digital electronic meter whose execution, mechanical and electrical arrangement, as well as the implementation of hardware and software, are in accordance with all the current rules of the field of legal metrology. This meter is managed by a firmware that performs the association of measuring elements, standardizing and limiting usage settings, making it highly secure and standardized for use in business relationships with auditing, traceability and certification requirements. The meter is of the bottom connect type, direct connection, whose detachable terminal block facilitates its installation and replacement.

## Description

### FIELD OF THE INVENTION

The present utility model describes a digital electronic meter of electrical quantities with six or more measuring elements. More specifically it comprises a digital electronic meter, whose execution, mechanical and electrical arrangement, as well as the implementation of hardware and software, are in accordance with all the current rules of the metrology legal field. This meter is managed by a firmware that performs the association of measuring elements, standardizing and limiting usage settings, making it highly secure and standardized for use in business relationships with auditing, traceability and certification requirements. The meter is of the bottom connect type, direct connection, whose detachable terminal block facilitates its installation and replacement.

In order to clarify what patentability is required, it is necessary to make a broader and historical explanation of the practices in the measurement of electrical quantities. To be more objective, we will be dealing with electric energy measurement, main magnitude of the present scope.

Electric power distribution systems throughout the world are one, two or three phases, two, three or four wires, so are the loads to be measured.

According to Blondel's theorem, the number of elements of a meter must be equal to the number of wires connected to the load, minus one, in this way the meters have always been manufactured with one, two or three measuring elements, both electromechanical such as electronics.

With the tremendous growth of electricity use, measurement and control needs have become broader and more complex in large industrial plants and large urban centers.

Thus, in order to detail the application field of meters with more than three (3) elements of measurement, we mention some examples:
In a first application, we mention a big company that is powered by a Substation serviced in transmission voltage, through two independent circuits, mainly for security. Then this complex load is served by more than four wires, so a three-element meter does not meet the need, then an arrangement is used with two meters of three elements, making the partial measurements and adding the two measurements.

This arrangement is not so simple, it is sufficient only for the calculation of the energy consumed, but there is a component, called demand, that requires summation in real time, as well as the actions of charge control and power factor, which does not are contemplated. In order to obtain the necessary data, we use digital output meters of the high-resolution values measured, and send to a computer equipment, which with appropriate software provides the necessary information.

As we have seen, we meet the need with an arrangement of existing equipment, some of generic use, without innovating. Thus, it should be noted that a single electric magnitude meter with six measuring elements, with the appropriate software, would meet all needs, with greater accuracy, reliability and lower cost.

In another application, we have in a control panel, four meters of three elements, monitoring individually the electrical powers demanded by four three-phase motors, that vary continuously, according to the required mechanical effort. The meters send signals to a control center that regulates the incoming material in the mills coupled to the motors so as not to exceed the nominal power of each motor and still allowing the total demanded electrical power of the assembly not to exceed a scheduled threshold, in a load management action, in order to optimize the use of electric power. Another arrangement of measurement of electrical quantities, which could be replaced, with great practicality, reliability and economy, by a meter with twelve elements.

In this way, hundreds of arrangements and measurement systems are proposed and implemented to meet both technical and operational needs, being the most diverse and with varied motives. Note that meters with six or more measuring elements apply with advantages both in a single-power supply consumer group and in a single consumer with more than one power supply.

One of the segments that has presented the most proposals for arrangements and measurement systems is linked to the measurement destined to the billing of consumers served in low voltage, mainly in groups of consumers, where the centralized measurement systems can mean greater control about possible fraud and facilitate automated reading and cutting actions.

These arrangements are used with the most varied implementation techniques, providing the main components of metrology in cabinets, where the current sensors corresponding to the measuring elements, sufficient to meet a certain group of consumers installed, and the signals, with lower or higher level of treatment, depending on the arrangement, are taken to a local processing center of common use, where through appropriate software, they process the corresponding values to the connected consumers at that point of supply. They can be provided with local displays and send signals to remote displays, AMR devices as well as remote cut and reconnect. The results obtained are unsatisfactory due to the difficulties of installation, operation and maintenance, since the assemblies are expensive, heavy and bulky.

Because they are systems and arrangements, there is no standardization, no regulations or rules, no manufacturing or quality audited. Also, the costs of these systems are high and only justified when usage becomes very necessary.

At the beginning, electromechanical meters with one, two or three measuring elements of a single magnitude, kWh or kvarhi or kvarhc, etc. were used. Making a meter with more than three elements made no sense because it was not feasible to associate the elements advantageously technically or economically.

With the emergence of analogue electronic meters, the situation did not change, there remained the lack of technical and economic advantages.

But with the use of modern digital techniques for the implementation of electric magnitudes meters for multi-magnitudes and multi-fees, everything radically changes in this scope of the technology.

At the current state of the art, current and voltage signals in any electric magnitude meter are converted by analogue/digital converters and consequently it is only mathematical, operations which follow instructions contained in a software, and the results are made available, in different ways, according to the application.

Therefore, the execution of meters with more than three measuring elements has become quite feasible, both from a technical and economic point of view. The great difficulty of associating measuring elements has become simple and inexpensive, thanks to combined hardware and software techniques. So, if before we had standardized mechanical arrangement and electrical layout, today we also have hardware and software, as standard items and mandatory certification.

Over time, several ideas have been presented to collaborate on group or centralized measurement. Based on a research carried out in the state of the art we have identified several patent documents describing new constructive arrangements in arrangements, systems and methods to improve and collaborate with group or centralized measurement, where we can highlight the following documents:
CN 2140526 relates to a watt-hour multi-user system belonging to a meter used for continuous measurement of multiple user electricity electric power consumption in a residential building. The utility model is mainly composed of a voltage transducer, a current transformer, a multiplex switching switch analog signal, a sequence signal, a holding device, an A/D converter, a monolithic piece computer application, and an eight-digit LED display. The utility model has the advantages of low cost, low power consumption and high accuracy. The utility model can be used to measure continuous power consumption for consumers in 24 households, the measurement result is processed by a computer, and the utility model makes financial settlement more convenient.
CN2153065 refers to a magnetic electric power meter card for many users in electromagnetic measurement. The utility model is composed of a control handler with a single computer chip, such as a core, a sample circuit that is connected to the control treatment device consisting of a pressure/pressure converter, an A/current pressure converter, a reading/magnetic card device, an electromagnetic counter, a relay and a writing screen. The utility model realizes that several users can share a set of electric power meter to automatically measure the electrical quantity, as well as the load and the fee to pay. The utility model can help the power department to strengthen management, realize the use of electric power and charge the fee are implemented synchronously, and improve the awareness of the electric power use at the time and save the electricity of users. Compared to other electric power meters, the electric power meter has the advantages of low cost and material saving
CN2716843 discloses a single-phase multi-user meter belonging to the electrical power metering device. The utility model comprises a housing, an electronic meter, a circuit board, and a current divider. The utility model is characterized by the fact that the current divider is a combined current divider; an output line of a combined current divider power supply is led out of the lower side of the housing; the utility model is provided with a casing and a plurality of units disposed in the metering box; each metering unit is composed of a circuit board and an electronic meter arranged on the circuit board; a plurality of metering units are horizontally and vertically disposed and are secured in the casing; one end of the cover is provided with a four-line wire of the three-phase power supply.
US2006033488 discloses a group metering method (and system) for monitoring electrical power consumption by a plurality of nearby users replacing multiple meters per individual users by a single electronic meter. A single computational engine computes the values of energy consumed by users and has a unique subsection set (display screen, real-time clock, and non-volatile memory) that can be located on a PCB. The system, usable for single or three-phase, can be located out of the reach of users to make it tamper proof. Individual ADCs obtain electrical current values (through current transformers) from the power consumed by individual users and cooperate with a single DSP to compute the energy consumption by individual users readable on a common display screen in a non-order identification mode. Differences between the sum of the energy values consumed by the users and a consolidated energy reading beyond a known threshold are reported as possible violations per user. Asynchronous communication ports communicate with display screen units and AMR modules.
US2016033561 discloses a modular metering unit comprising a master module, slave modules and a communication module. Together, the modules comprise a modular metering unit for measuring electric power from plural loads (not shown). Each of the slave modules includes electric power meters to measure the energy supplied to a load. The loads can be located remotely from the metering unit and each has a current detector which feeds a low voltage signal back to the meter through a cable (not shown). The slave modules are connected to one another and to the master module by an internal bus, through which data and power are realized between the modules.
CN102323461 discloses a case body which is characterized in that a main control display unit is disposed in the case body and is provided with the connected communication unit and multi-user metering device; each user's power consumption is acquired by the multi-user metering device and the information is transmitted to the master control display unit; a signal is calculated by the master control display unit and a result is displayed, so that centralized meter reading, management and control are facilitated. The meter case has the advantages of acquiring large capacity ample information, reduced loss, energy conservation, material savings and capabilities to improve metering accuracy and meter efficiency, simplifying operation.
CN203519724 discloses a multi-user electric power meter comprising an A, B housing and phase C wiring lines which are respectively connected with cable end input A, B and C, a wire output terminal and a function module. The housing comprises a base, a face cover which is fixedly connected with the upper side of the base and a side cover which is fixedly connected with the right side of the base. The multi-user electric power meter has the advantages of a modular form of structure employed, with the MCU as the core, each house is equipped with an independent and removable measuring control module, measurement accuracy is high, selection and maintenance are convenient, the structure is simple, the wire layout is convenient, and the anti-interference capability is strong.

All the documents cited in the state of the art seek the same objective, but although some titles mention electric power consumption meters, they are presented as method, system or measurement arrangement.

These propositions, with their limitations, would apply to any use that does not include a business transaction. The measurement of electric power for the purpose of issuing an invoice requires that the equipment used be manufactured in conformity with the standards in force in each country, which are usually extensions of international standards.

Electronic power energy meters for invoice purposes are defined in international standards such as International Electrotechnical Commission IEC 62052-11 and International Organization for Standardization Recommendations R46-1 and R46-2 (International Document D-27) of International Organization of Legal Metrology (OIML), as well as in Brazil, in standards NBR14519, NBR14520 and NBR14521 of the Brazilian Association of Technical Standards (ABNT) and Resolutions 587 and 586 - Technical Metrological Regulation of the National Institute of Legal Metrology.

Thus, it is evident that current state-of-the-art solutions lack solutions for application in legal metrology, manufacturability and ease of operation. It is necessary to solve the questions of standardized manufacturing, association of measurement elements for the formation of single-phase, two-phase and three-phase meters, predetermined at the factory and a mechanical and electrical arrangement allowing operation, installation and maintenance in a practical, safe and economical way.

It is in this context that we present our solution, which we consider a worldwide innovation, in the field of the practices used in power measurement and other electric magnitudes, including the measurement of electric power for billing.

In a study, considering technical and practical feasibility, cost-benefit ratio and industrial scale production, we observed the best application for single, two, three, six, nine, or twelve measurement element meters.

Thus, the present utility model is an electronic digital meter of electrical quantities with six or more measuring elements that comprises a digital electronic meter whose execution, mechanical and electrical arrangement, as well as the implementation of hardware and software, are of accordance with all current standards of the legal metrology sector. This meter is managed by a firmware that performs the association of measuring elements, standardizing and limiting usage settings, making it highly secure and standardized for use in business relationships with auditing, traceability and certification requirements. The meter is of the bottom connect type, direct connection, whose detachable terminal block facilitates its installation and replacement.

Such features promote greater practicality, reliability and economy when compared to the arrangements, systems and methods identified in the prior art.

It is characteristic of this utility model a digital electronic meter of electrical quantities with six or more elements of measurement, whose execution, mechanical and electrical arrangement, as well as the implementation of hardware and software, are in agreement with all the current norms of the sector of metrology cool.

It is characteristic of this utility model a digital electronic meter of electrical quantities with six or more elements of measurement that presents a firmware that realizes the association of the measuring elements, standardizing and limiting the use configurations, making it highly safe and standardized, for use in commercial relations, with auditing, traceability and certification requirements.

It is characteristic of this utility model a digital electronic meter of electrical quantities with six or more elements of measurement that presents a firmware that is factory loaded together with the manufacturing process, controlled and authorized, in order to prevent its modification without violating the meter seals.

It is characteristic of this utility model a digital electronic meter of electrical quantities with six or more measuring elements that is bottom connect type for direct connection, whose detachable terminal block facilitates its installation and replacement.

It is characteristic of this utility model a digital electronic meter of electrical quantities with six or more measuring elements that has functions of metrology, reliability of operation, safety of operation, ability to be self-sufficient so as not to depend on external devices, offer fast and practical means audits and have standardized records of traceability and inviolability.

It is characteristic of this utility model a digital electronic meter of electrical quantities with six or more elements of measurement enable the standardized and documented manufacturing according to the requirements established by the current rules that are regulated by the metrology organs.

In order to better describe the technical features of the digital electronic meter of electrical quantities having six or more measuring elements, the following figures are shown:

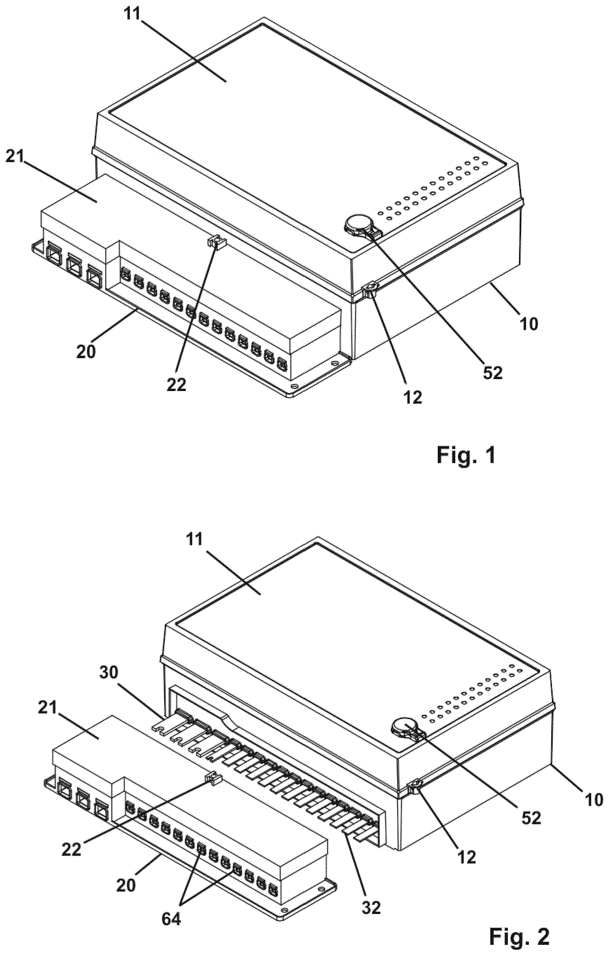

Figure 1 shows the perspective view of the mounted meter.
Figure 2 shows the perspective view of the meter with the highlighted block of the assembly.

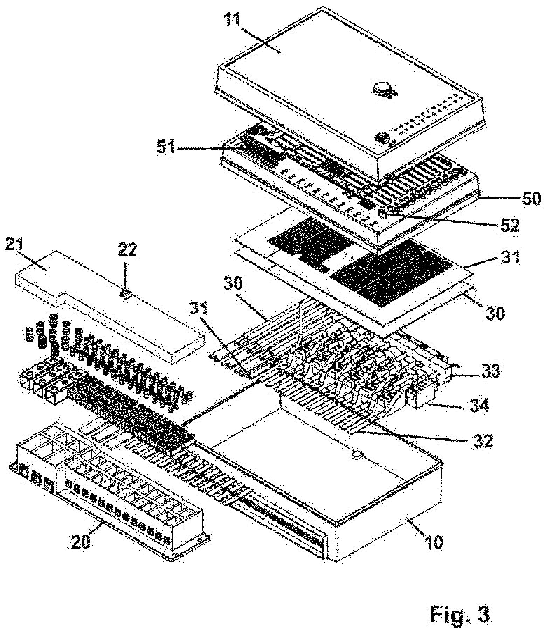

Figure 3 shows the exploded view of the meter having a detachable block.

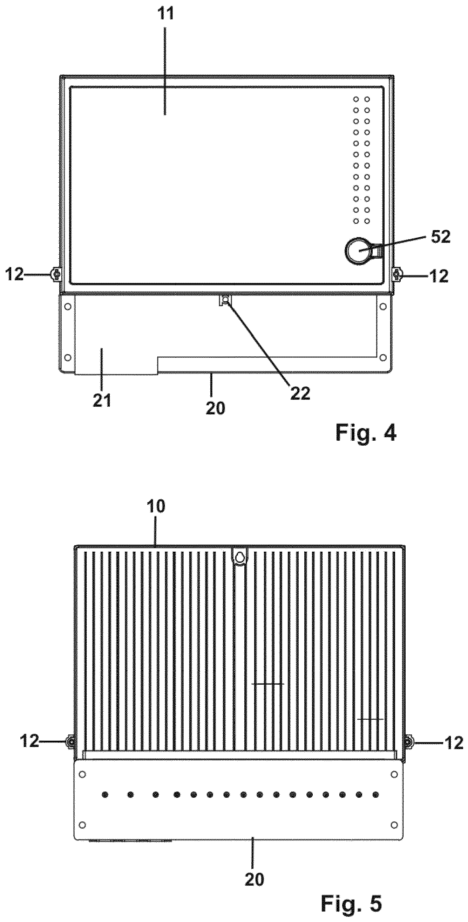

Figure 4 shows the front view of the mounted meter.
Figure 5 shows the rear view of the mounted meter.

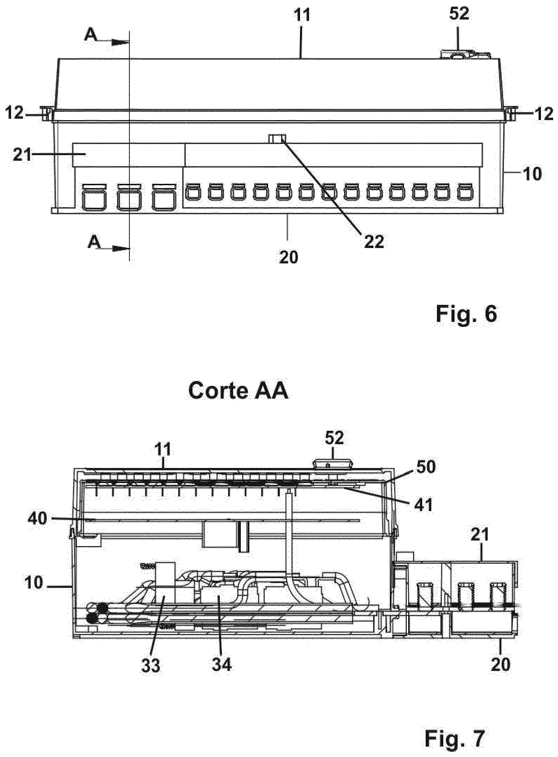

Figure 6 shows the bottom view of the mounted meter showing the terminal block.
Figure 7 shows the cross-sectional view of the mounted meter.

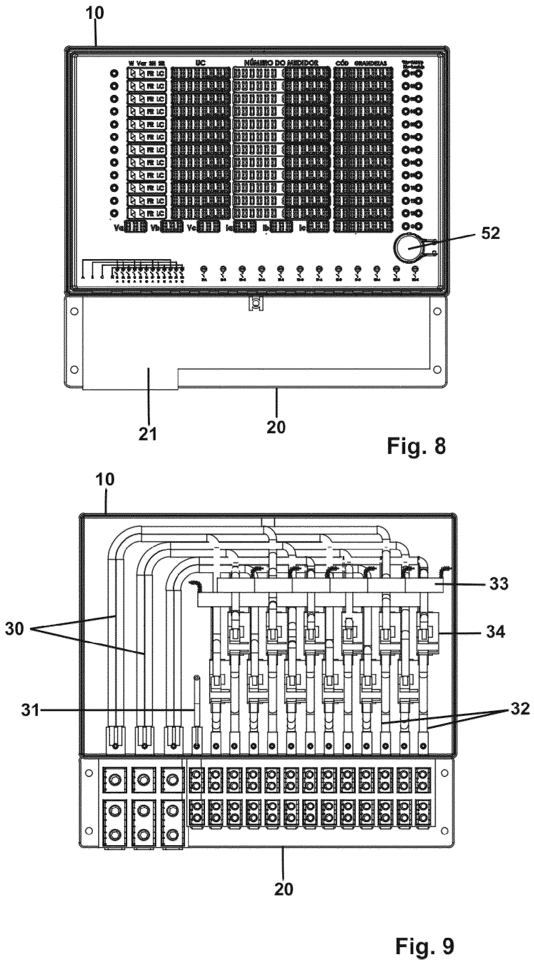

Figure 8 shows the front view of the meter without the lid.
Figure 9 shows a view of the arrangement of current circuits, current transformers and relays.
Figure 10 shows the example of implementation of the meter.

For ease of narrative, we will make all the mentions and descriptions for a meter of 12 (twelve) measuring elements, without, however, invalidating the claim of patentability, for meters with six or more measuring elements.

Said meter is equipped with all the components, which today, in the current state of the art, comprise digital electronic meters with one, two or three elements, modern and standardized through national and international standards, as well as legal metrological regulations.

The digital electronic host meter of electrical quantities with six or more measuring elements, object of this utility model, consists basically of a base (10) intended for its installation and on which the structure, the meter lid (11), is fixed, the terminal block (20) and the terminal block lid (21), as described in the ABNT standard NBR14519.

The meter lid (11) is overlapped to the base to cover and protect the internal parts of the meter, being provided with a sealing mechanism (12) required to maintain the inviolability of the host meter.

The terminal block (20) is an insulating material support that groups the terminal meter being preferably detachable and of the bottom connect type. The mechanical arrangement with the detachable terminal block (20) is not contemplated in any known standard but it is desirable because of the large number of connecting cables to be handled in the connections and replacements, of twelve-element meters.

The terminal block lid (21) is intended to cover and protect the terminal block (20), the lower meter fixation holes, and the block housing, when it exists. Being provided with a sealing mechanism (22) required to maintain the inviolability of the terminal block.

The meter is internally constituted by three (3) line terminals (30), one (1) neutral terminal (31) and twelve (12) charging terminals (32). The terminals are interconnected to the current transformer type sensors (33) and cut-off and reclosing relay (34), one for each current circuit.

The main electronic board (40) has registers stored in non-volatile memory, implemented in order to guarantee high integrity of the recorded data, in a number defined by the firmware, according to the need of the application. The board (40) has resistive divider type voltage sensors, one for each voltage circuit. The board is interconnected to a display (41), LCD or similar, according to the application.

The type plate (50) presents all the mandatory data of the standard and other, as the need. The plate (50) has a single line diagram (51), of the meter connection scheme and communication ports (52) according to the implemented implementations.

All the above items must comply with the definitions of the aforementioned standards.

Said meter can be presented with basic software, such as an operating system, which can support the development of programs directly by the user, offering a wide variety of applications.

However, for billing purposes, the proposal of this utility model, with electric energy charging, actions involving commercial transaction, the electric power meter must have specific characteristics, regulated by the legal metrology organs of each country and duly certified by those.

The essential basic characteristics of these meters, besides the metrology functions, are reliability of operation, safety of operation, ability to be self-sufficient, not depend on external devices, provide fast and practical means of audibility, have standardized records of traceability and inviolability.

It should be characteristic of these meters the standardized and documented manufacture according to the legal metrological legislation, and it should be identical replicas of the models tested and approved, with their respective model approval directives.

For these reasons, it is characteristic of this meter, to have a factory loaded firmware in the controlled and authorized manufacturing process, which cannot be modified without tampering with the meter seals (12).

This firmware limits and standardizes the usage configurations of its twelve (12) measuring elements, creates combinations of these elements, which follow a unique formula, resulting in the generation of twelve (12) individual element meters, eleven (11) specific meters of two elements and ten (10) specific meters of three elements.

These generated meters, which are the possibilities of use, offered by the versatility of the twelve-element meter, are numbered and registered by the firmware, obey a single formula, approved in the model tests, and no other combination can be allowed by the meter.

The specific meters are recorded by a numbering resulting from a prefix, which is the number of the basic twelve (12) element meter, which corresponds to the patrimonial number, plus a suffix, corresponding to the outputs or load terminals used, which are designated from one (1) to twelve (12), as listed below.

For these thirty-three (33) meters, all test and assays procedures are performed during manufacturing as if they were individual, following the recommendations of the legal metrology body of each country, and issued the calibration reports.

A table of numbering of the internal meters for a twelve-elements meter is thirty-three (33) predetermined meters, as can be seen:

| 1 (one) element | 2 (two) elements | 3 (three) elements |
|---|---|---|
| XXXXXXX010000 | XXXXXXX010200 | XXXXXXX010203 |
| XXXXXXX020000 | XXXXXXX020300 | XXXXXXX020304 |
| XXXXXXX030000 | XXXXXXX030400 | XXXXXXX030405 |
| XXXXXXX040000 | XXXXXXX040500 | XXXXXXX040506 |
| XXXXXXX050000 | XXXXXXX050600 | XXXXXXX050607 |
| XXXXXXX060000 | XXXXXXX060700 | XXXXXXX060708 |
| XXXXXXX070000 | XXXXXXX070800 | XXXXXXX070809 |
| XXXXXXX080000 | XXXXXXX080900 | XXXXXXX080910 |
| XXXXXXX090000 | XXXXXXX091000 | XXXXXXX091011 |
| XXXXXXX100000 | XXXXXXX101100 | XXXXXXX101112 |
| XXXXXXX110000 | XXXXXXX111200 | |
| XXXXXXX120000 | | |

Thus, the representation of "XXXXXXX" described in the above table corresponds to the basic meter patrimonial number of twelve (12) elements. And the other numbers correspond to the outputs used by the specific meter.

It is characteristic of this meter to function as a host, storing a stock of 33 (thirty-three) specific, ready-to-use meters.

Likewise, a meter of nine (9) measuring elements results in twenty-four (24) specific meters and a meter of six (6) measuring elements results in fifteen (15) specific meters.

Note that the specific meter number indicates which outputs, load terminals, are being measured. Other combinations are prevented by firmware. Some meters, although existing and registered, cannot be used simultaneously because they share one or more measurement elements.

During installation, when the appropriate meter is chosen for the load to be measured, the firmware requires a code, which identifies it, to be registered in the case of a consumer, normally the NUC (consumer unit number), which within an energy provider scope, is never repeated.

When a meter is prevented from being used because of a meter that is already in use, and that shares some of its measuring elements, this meter does not disappear, it is in the future disposition, if there is any change of use, that releases its measuring elements. All specific meters, on and off, throughout use remain with their history recorded in the main record of the twelve (12) element basic meter, allowing for audits in previous records when necessary.

The mechanical arrangement of the meter should allow the terminal block (20) to detachable, without changing its original form, submitted for certification of the model, to the legal metrology body.

The detachable terminal block (20) must connect the meter in two stages, first to the line terminals (30) and subsequently to the charging terminals (32). This procedure aims to enable the cut-off and reclosing relays (34) to be properly positioned prior to connection to the load terminals (30), thus avoiding undesired circuit energization.

### EXAMPLES OF IMPLEMENTATION

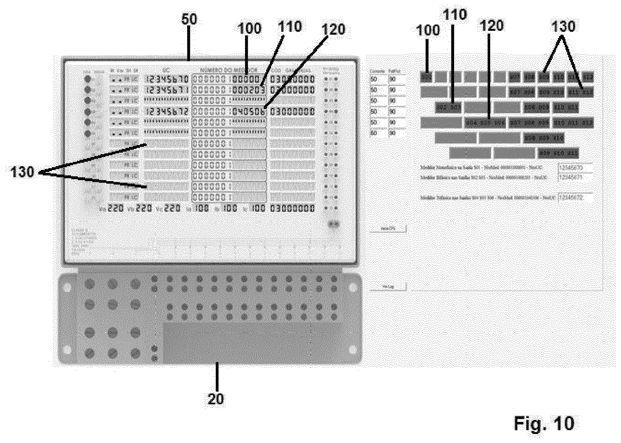

Figure 10 shows the representation of the association of the elements and respective outputs for a twelve-element meter, where we have a single-phase consumer connected at the output 01 (100), a two-phase consumer connected at the outputs 02 and 03 (110), a three-phase consumer in the outputs 04, 05 and 06 (120), the other outputs (130) are available for other connections.

Thus, the object of the present utility model is an digital electronic meter of electrical quantities with six or more measuring elements that comprises a digital electronic meter whose execution, mechanical and electrical arrangement, as well as the implementation of hardware and software, are in accordance with all the current regulations of the legal metrology field. This meter is managed by a firmware that performs the association of measuring elements, standardizing and limiting usage settings, making it highly secure and standardized for use in business relationships with auditing, traceability and certification requirements. The meter is bottom connect type, direct connection, whose detachable terminal block (20) facilitates its installation and replacement.

## Claims

1. A digital electronic meter of electrical quantities with six or more measurement elements basically consists of a base (10) intended for its installation and on which the structure is fixed, the meter lid (11) arranged with a sealing mechanism (12), the terminal block (20) and the terminal block lid (21) disposed with sealing mechanism (22), being internally constituted by line terminals and load terminals interconnected to the current transformer type sensors (33) and cut-off and reclosing relay (34), by main electronic board (40) and type plate (50) which presents all mandatory data of standard, **characterized in that** is factory-loaded firmware in the manufacturing process, controlled and authorized, which cannot be modified without tampering with the meter seal (12), describing the following characteristics:
a) limits and standardizes the usage configurations of its twelve (12) measuring elements;
b) creates combinations of these elements, which follow a unique formula, resulting in the generation of twelve (12) specific meters of one element, eleven (11) specific meters of two elements and ten (10) specific meters of three elements;
c) the specific meters are recorded by a numbering resulting from a prefix, which is the basic twelve (12) element meter number corresponding to the patrimonial number, plus a suffix, corresponding to the outputs or load terminals used;
d) the specific meter number indicates which outputs, load terminals, are being measured, and other combinations are impeded by the firmware, some meters, although existing and registered, cannot be used simultaneously because they share one or more measurement elements;
e) during installation, when the appropriate meter is chosen for the load to be measured, the firmware requires a code, which identifies it, is registered in the case of a consumer, will normally be the NUC (consumer unit number), which within an energy provider scope, is never repeated;
f) when a meter is prevented from being used because of a meter that is already in use, and that shares some of its measuring elements, this meter does not disappear, it is at the future disposal, if there is any change of use, that releases its measuring elements;
g) all specific meters on and off during use remain with their history recorded in the main record of the twelve (12) element basic meter, allowing audits in previous records, when necessary;
h) all test and assay procedures are performed in the meters during manufacturing, as if they were individual, following the recommendations of the legal metrology body of each country, and issuing the calibration reports;
the mechanical arrangement of the meter allows the terminal block (20) to be detachable and the bottom connect type, without changing its original form, presented for the certification of the model, to the legal metrology body; the detachable terminal block (20) must connect the meter in two stages, first to the line terminals (30) and subsequently to the charging terminals (32).

2. A digital electronic meter of electrical quantities with six or more measurement elements, according to claim 1, **characterized in that** the meter functions as a host, storing a stock of thirty-three (33) specific, ready-to-use meters.

3. A digital electronic meter of electrical quantities with six or more measurement elements, according to claim 1, **characterized in that** a meter of nine (9) measuring elements results in twenty-four (24) specific meters and a meter of six (6) measuring elements results in fifteen (15) specific meters.

4. A digital electronic meter of electrical quantities with six or more measurement elements, according to claim 1, **characterized in that** the detachable terminal block (20) carries out the connection with the meter in two stages, so as to enable the cut-off and reclosing relays (34) are properly positioned prior to connection to the load terminals (30), avoiding undesired circuit energization.

5. A digital electronic meter of electrical quantities with six or more measurement elements, according to claim 1, **characterized in that** the electric power meter meets any requirements established by the industry standards in force.

6. A digital electronic meter of electrical quantities with six or more measurement elements, according to claim 1, **characterized in that** its execution complies with all industry standards, for mechanical and electrical arrangements, and for hardware and software implementations.

7. A digital electronic meter of electrical quantities with six or more measurement elements, according to claim 1, **characterized in that** the firmware makes the meter highly secure, standardized for use in commercial relations, with audibility, traceability and certification requirements.
